# EUROPÄISCHE PATENTSCHRIFT

(11) **EP 2 989 474 B1**
(45) Veröffentlichungstag und Bekanntmachung des Hinweises auf die Patenterteilung: **27.01.2021**
(21) Anmeldenummer: 14728930.0
(22) Anmeldetag: 05.06.2014
(51) Int. Cl.: G01R 31/26

(54) **BEREITSTELLEN EINER INFORMATION ÜBER EINEN ALTERUNGSZUSTAND EINES HALBLEITERBAUELEMENTS**
PROVISION OF INFORMATION ON AN AGEING STATUS OF A SEMICONDUCTOR COMPONENT
FOURNITURE D'UNE INFORMATION CONCERNANT L'ÉTAT DE VIEILLISSEMENT D'UN COMPOSANT À SEMI-CONDUCTEUR

(30) Priorität: 13.06.2013 DE 102013211038
(43) Veröffentlichungstag der Anmeldung: 02.03.2016
(73) Patentinhaber: Siemens Mobility GmbH, 81739 München (DE)
(72) Erfinder: BOHLLÄNDER, Marco, 91058 Erlangen (DE)
(86) Internationale Anmeldenummer: PCT/EP2014/061651
(87) Internationale Veröffentlichungsnummer: WO 2014/198617

(56) Entgegenhaltungen:
- DE-A1- 3 832 273
- DE-A1-102010 000 875
- John Sofia: "Fundamentals of Thermal Resistance Measurement", Analysis Tech, 1. Januar 1995 (1995-01-01), Seiten 1-50, XP055139452, Gefunden im Internet: URL:http://samunet.hu/extfil/Temperature_s aturation_voltage.pdf [gefunden am 2014-09-10]

## Beschreibung

Die vorliegende Erfindung betrifft ein Verfahren zum Bereitstellen einer Information über einen Alterungszustand eines Halbleiterbauelements der Leistungselektronik. Insbesondere soll eine derartige Information über ein Halbleiterbauelement eines Stromrichters eines elektrisch betriebenen Fahrzeugs oder Windrads bereitgestellt werden können. Darüber hinaus betrifft die vorliegende Erfindung eine Leistungshalbleitervorrichtung, die eine entsprechende Information über den Alterungszustand eines Halbleiterbauelements bereitstellt.

Leistungshalbleiter altern. Analog zu dem Profil eines Autoreifens nutzen sich Leistungshalbleiter (IGBT, Diode, MOSFET etc.) bis hin zum Ausfall ab. Bei Einsatz des Leistungshalbleiters in einem Stromrichter eines elektrisch betriebenen Fahrzeugs kann ein solcher Ausfall zu einem spontanen Totalausfall der Stromrichterendstufe, in dessen Folge das Kraftfahrzeug fahruntüchtig ist, führen. Ähnlich wie bei Autoreifen, deren Profilabnutzung von den Fahrbahneigenschaften, dem Fahrverhalten des Fahrers und vom Wetter abhängt, altert der Leistungshalbleiter ebenfalls in Abhängigkeit vieler Applikationsparameter unterschiedlich schnell. Anders jedoch als beim Autoreifen kann der Alterungszustand des Leistungshalbleiters nicht mit Sichtprüfung ermittelt werden. Zur Messung des Lebensdauerverbrauchs ist die virtuelle Sperrschichttemperatur (nur indirekt messbar) notwendig und darüber hinaus die Durchlassspannung bei Laststrom zweckmäßig. Die virtuelle Sperrschichttemperatur (gemessen mit einem Messstrom) in Verbindung mit der Verlustleistung, die diese virtuelle Sperrschichttemperatur erzeugt gibt Auskunft über den inneren Alterstzustand des Halbleiters, während die Durchlassspannung bei Laststrom (zwei bis vier Größenordnungen größer als der Messstrom) Auskunft über den Zustand der Chipoberseitenkontaktierung gibt.

Diese Messmethoden werden bei Lastwechseltests angewandt. Lastwechseltests sind in der Entwicklungs-/ Qualifizierungsphase der Leistungshalbleiter stattfindende Typprüfungen, anhand deren Ergebnisse die Lebensdauerkurven der Leistungshalbleiter ermittelt werden. Dazu müssen die Leistungshalbleiter vor Testbeginn zur Bestimmung der virtuellen Sperrschichttemperatur (im Folgenden auch kurz "Sperrschichttemperatur") selektiv kalibriert werden. Die heute übliche Methode, die "passive Kalibrierung", bei der der Halbleiter von außen erwärmt wird, muss mit Zusatzequipment durchgeführt werden (Wärmekammer oder Heizplatte) und kann nicht im Einsatzort (Umrichter) erfolgen.

Bislang wurde im Vorfeld während der Produktentwicklung berechnet, wie lange der jeweilige Leistungshalbleiter seine Funktion erfüllt. Zur Schätzung der Lebensdauer der Leistungshalbleiter im Kraftfahrzeugbereich werden verschiedene Fahrprofile in einer Lebensdauersimulation an den Lebensdauerkurven der Leistungshalbleiter gespiegelt. Die Qualität der Rechnung ist zum einen vom Praxisbezug des Fahrprofils abhängig und zum anderen von der späteren Realität, also ob sich der Fahrer des elektrisch betriebenen Fahrzeugs tatsächlich an das Fahrprofil des Herstellers hält. Letzteres ist vermutlich eher selten der Fall. Eine Messung des Lebensdauerverbrauchs bzw. der Alterungsrate im Feld erfolgt bislang nicht.

Aus der nachveröffentlichten DE 10 2012 005 815 ist ein Verfahren zur Ermittlung der Temperaturkalibrierkennlinie eines Halbleiterbauelements der Leistungselektronik bekannt. Dazu werden die Leistungsanschlüsse des Halbleiterbauelements mit einer ersten Stromquelle für einen Laststrom, mit einer zweiten Stromquelle für einen Messstrom, mit einem Voltmeter zur Messung der über entweder die Leistungsanschlüsse oder mit den Leistungsanschlüssen verbundenen Hilfsanschlüsse abfallenden Spannung zusammengeschaltet. Weiterhin wird das mit einem Datenverarbeitungssystem verbundene Halbleiterbauelement in Intervallen bei zugeschalteter erster Stromquelle über dessen Verlustleistung erwärmt. Die bei abgeschalteter erster Stromquelle und zugeschalteter zweiter Stromquelle über die Leistungs- oder Hilfsanschlüsse abfallende Spannung zwischen den Intervallen nach einer durch die thermische Hauptzeitkonstante des Halbleiterbauelements bestimmten Zeitdauer wird als die Temperatur repräsentierenden Werte gemessen. Gleichzeitig wird die Temperatur mittels wenigstens einen an das Halbleiterbauelement gekoppelten und mit dem Datenverarbeitungssystem zusammengeschalteten Temperatursensors erfasst und die jeweilige Temperatur dem Spannungswert zugeordnet. Die Werte und die Temperaturen bilden nach einer Näherung die Kalibrierkennlinie des Halbleiterbauelements.

Die DE 10 2010 000 875 A1 lehrt ein Verfahren zur Bestimmung der Sperrschichttemperatur eines Leistungstransistors in einem Stromrichter. Das Verfahren kann zudem zur Erkennung von Alterungserscheinungen und zur Prognose der Restlebensdauer des Leistungshalbleiters verwendet werden, indem der Wärmewiderstand des Leistungstransistors berechnet wird.

Weiterhin lehrt die WO 2013/ 075 733 A1 ein Verfahren zur Lebensdauerüberwachung von Leistungstransistoren. Dazu wird ein unbelasteter Referenztransistor zusammen mit den Leistungstransistoren auf einem gemeinsamen Substrat angeordnet. In einem Testmodus wird der Referenztransistor und mindestens ein Leistungstransistor mit einem Prüfstrom beaufschlagt, wobei das Verfahren zur Überwachen der Leistungstransistoren nunmehr deren zu erwartende Rest-Lebensdauer ermittelt.

Darüber hinaus lehrt die DE 38 32 273 A1 ein Verfahren zur Wärmewiderstandsmessung, bei dem die Kollektor-Emitter-spannung eines IGBTs vor und nach einem definierten Leistungsimpuls gemessen wird, sowie durch ein Verfahren zur Bestimmung des transienten Wärmewiderstandes durch Erfassung der Abkühlkurve nach dem Leistungsimpuls, und zwar durch Messung der Kollektor-Emitterspannung in bestimmten Zeitabständen. Die Verfahren können mit einer an einen Rechner angeschlossenen Messeinrichtung durchgeführt werden. Die erfindungsgemäße Lösung kann zur Prüfung von IGBT-Modulen angewendet werden.

Die Aufgabe der vorliegenden Erfindung besteht darin, die Alterung eines Halbleiterbauelements im Feld besser feststellen zu können.

Erfindungsgemäß wird diese Aufgabe gelöst durch ein Verfahren zum Bereitstellen einer Information über einen Alterungszustand eines Halbleiterbauelements der Leistungselektronik durch
- vor Inbetriebnahme des Halbleiterbauelements:
   ∘ Ermitteln einer Kennlinie einer Temperatur des Halbleiterbauelements gegenüber einer elektrischen Spannung an dem Halbleiterbauelement bei einem Messstrom und
   ∘ Ermitteln eines Widerstandsreferenzwerts eines thermischen Widerstands des Halbleiterbauelements aus dem Quotienten eines Temperaturhubs und einer Verlustleistung des Halbleiterbauelements,
- nach Inbetriebnahme des Halbleiterbauelements:
   ∘ Messen einer Spannung an dem Halbleiterbauelement bei dem Messstrom und Bestimmen eines Temperaturreferenzwerts aus der gemessenen Spannung anhand der Kennlinie,
   ∘ Erwärmen des Halbleiterbauelements durch einen eine Verlustleistung hervorrufenden Laststrom, Messen einer aktuellen Spannung bei dem Messstrom an dem Halbleiterbauelement nach dem Erwärmen und Bestimmen eines aktuellen Temperaturwerts aus der aktuellen Spannung anhand der Kennlinie,
   ∘ Bestimmen eines aktuellen thermischen Widerstandswerts des Halbleiterelements aus einem Temperaturhub, der zwischen dem aktuellen Temperaturwert und dem Temperaturreferenzwert ermittelt wird, und der Verlustleistung,
   ∘ Ermitteln eines Unterschieds zwischen dem aktuellen thermischen Widerstandswert und dem Widerstandreferenzwert und
   ∘ Ausgeben der Information über den Alterungszustand des Halbleiterbauelements in Abhängigkeit von dem Unterschied,
wobei ein Kommunikationssystem zur Integration vorgesehen ist, welches Informationen über den Alterungszustand von Halbleiterbauelementen mittels geeigneter Kommunikationsverbindungen übermittelt, und
wobei in Abhängigkeit von der ausgegebenen Information (Info) eine Leistung des Halbleiterbauelements gesteuert wird.

Darüber hinaus wird erfindungsgemäß bereitgestellt eine Leistungshalbleitervorrichtung für eine elektrische Maschine mit
- einem Halbleiterbauelement der Leistungselektronik,
- einer Speichereinrichtung, in der
   ∘ eine Kennlinie einer Temperatur des Halbleiterbauelements gegenüber einer elektrischen Spannung an dem Halbleiterbauelement sowie
   ∘ ein Widerstandreferenzwert eines thermischen Widerstands des Halbleiterbauelements aus dem Quotienten eines Temperaturhubs und einer Verlustleistung des Halbleiterbauelements gespeichert sind, und
- einer Messeinrichtung zum Durchführen folgender Schritte:
   ∘ Messen einer Spannung an dem Halbleiterbauelement bei einem Messstrom und Bestimmen eines Temperaturreferenzwerts aus der gemessenen Spannung anhand der Kennlinie,
   ∘ Erwärmen des Halbleiterbauelements durch einen eine Verlustleistung hervorrufenden Laststrom, Messen einer aktuellen Spannung bei dem Messstrom an dem Halbleiterbauelement nach dem Erwärmen und Bestimmen eines aktuellen Temperaturwerts aus der aktuellen Spannung anhand der Kennlinie,
   ∘ Bestimmen eines aktuellen thermischen Widerstandswerts des Halbleiterelements aus einem Temperaturhub, der zwischen dem aktuellen Temperaturwert und dem Temperaturreferenzwert ermittelt wird, und der Verlustleistung,
   ∘ Ermitteln eines Unterschieds zwischen dem aktuellen thermischen Widerstandswert und dem Widerstandreferenzwert und
   ∘ Ausgeben einer Information über einen Alterungszustand des Halbleiterbauelements in Abhängigkeit von dem Unterschied,
wobei ein Kommunikationssystem zur Integration vorgesehen ist, welches Informationen über den Alterungszustand von Halbleiterbauelementen mittels geeigneter Kommunikationsverbindungen übermittelt, und
wobei in Abhängigkeit von der ausgegebenen Information (Info) eine Leistung des Halbleiterbauelements gesteuert wird.

In vorteilhafter Weise erfolgt vor Inbetriebnahme des Halbleiterbauelements, d.h. im Rahmen der Fertigung des Stromrichters, zunächst eine Kalibrierung des Halbleiterelements, bei dem eine Temperatur-Spannungs-Kennlinie aufgenommen und ein Widerstandsreferenzwert für den thermischen Widerstand des Halbleiters für den Abtransport von Verlustwärme nach außen ermittelt wird. Nach der Inbetriebnahme, d.h. während des bestimmungsgemäßen Feldeinsatzes des Halbleiterbauelements werden dann Spannungsmessungen vor und nach einem aktiven Erwärmen des Halbleiterbauelements durchgeführt. Aus den Spannungsmessungen wird dann auf einen Temperaturhub und aus dem Temperaturhub auf einen aktuellen thermischen Widerstand geschlossen. Eine Änderung des thermischen Widerstands ergibt Auskunft über den Alterungszustand des Halbleiterbauelements. Ohne großen Aufwand kann somit während des Feldeinsatzes des Halbleiterbauelements eine Information über seinen Alterungszustand gewonnen werden.

Bei dem aktuellen Temperaturwert, der aus der aktuellen Spannung anhand der Kennlinie gewonnen wird, handelt es sich vorzugsweise um die virtuelle Temperatur einer Sperrschicht des Halbleiterbauelements bzw. eine diese Temperatur repräsentierenden Wert. Damit wird also unmittelbar eine interne Halbleitertemperatur für die Schätzung der Alterung herangezogen und nicht eine Temperatur außerhalb des Halbleiterbauelements.

Günstigerweise ist der Messstrom um mindestens zwei Größenordnungen kleiner als der Laststrom. Besonders bevorzugt ist ein Messstrom, der zwischen 0,25 und 1 ‰ des Nennstroms bzw. Laststroms liegt. Da die Laststromquelle naturgemäß in dem Antriebsstrang eines elektrisch betriebenen Fahrzeugs vorhanden ist, bedarf es in der Regel zur Durchführung des erfindungsgemäßen Verfahrens lediglich einer zusätzlichen Messstromquelle kleinen Ausmaßes in der entsprechenden Halbleiteranordnung und einer Spannungsmessungseinrichtung.

Der Laststrom zum Erwärmen des Halbleiterbauelements kann gepulst sein. Damit ist es nicht zwangsläufig notwendig, mit Gleichstrom oder einem sinusförmigen Wechselstrom zu heizen.

Das Halbleiterbauelement kann (z.B. integriert in einen Stromrichter) an einer elektrischen Maschine angeschlossen sein, und die elektrische Maschine wird mit dem Laststrom zum Erwärmen des Halbleiterbauelements so bestromt, dass sich die elektrische Maschine im Wesentlichen nicht bewegt. Der Laststrom wird also für den Messzyklus ausschließlich zur Erzeugung von Verlustwärme genutzt.

Ferner kann es von Vorteil sein, wenn das erfindungsgemäße Verfahren zum Bereitstellen der Information über den Alterungszustand des Halbleiterbauelements unmittelbar vor dem Start oder nach einem Betriebsende der elektrischen Maschine erfolgt, die als Last an das Halbleiterbauelement angeschlossen ist. Damit kann dem Nutzer der elektrischen Maschine (z.B. Fahrer eines Kraftfahrzeugs) eine entsprechende Alterungsinformation oder eine korrespondierende Information gegeben werden.

Das Ermitteln der Temperatur-Spannungs-Kennlinie vor der Inbetriebnahme des Halbleiterbauelements kann günstigerweise mit denselben Mitteln erfolgen wie das Messen der Spannung an dem Halbleiterbauelement und das Erwärmen des Halbleiterbauelements nach Inbetriebnahme des Halbleiterbauelements. In diesem Fall werden sowohl zum aktiven Kalibrieren als auch zum späteren Messen dieselben Komponenten (z.B. Messstromquelle, Laststromquelle, Spannungsmesser etc.) verwendet. Damit werden systematische Fehler kompensiert, die sich unter Umständen ergeben würden, wenn unterschiedliches Equipment für Kalibrierung und Messung herangezogen werden würde.

Das Halbleiterbauelement kann Teil eines Stromrichters sein. Damit lässt sich beispielsweise ein zu erwartender Ausfall eines Stromrichters vorzeitig erkennen.

In einer speziellen Ausgestaltung ist das Halbleiterbauelement Teil einer von mehreren Halbbrücken des Stromrichters, wobei die Halbbrücken in Serie miteinander von einem Kühlmittelstrom gekühlt werden, und nur von der im Kühlmittelstrom letzten Halbbrücke wird der Alterungszustand geschätzt. Dies hat den Vorteil, dass nicht alle Halbbrücken separat hinsichtlich Alterung überwacht werden müssen. Vielmehr reicht es, wenn die im Betrieb wärmste Halbbrücke überwacht wird.

Erfindungsgemäß wird in Abhängigkeit von der ausgegebenen Information über den Alterungszustand eine Leistung des Halbleiterbauelements gesteuert. Somit kann beispielsweise die Leistung eines Stromrichters reduziert werden, wenn in naher Zukunft ein Ausfall des Halbleiterbauelements zu erwarten ist.

Wie bereits erwähnt, kann das erfindungsgemäße Verfahren bzw. die erfindungsgemäße Leistungshalbleitervorrichtung bevorzugt in einem Kraftfahrzeug oder einem Windrad ausgeführt werden bzw. integriert sein. Damit kann beispielsweise ein Fahrer rechtzeitig auf einen bevorstehenden Werkstatttermin hingewiesen werden.

Kommen die beispielsweise in Leistungshalbleitervorrichtungen integrierten Halbleiterbauelemente für einen Betrieb elektrischer Maschinen in Kraftfahrzeugen zum Einsatz, werden für einen anwendungsbezogenen Nutzer aus den Informationen über den Alterungszustand der Halbleiterbauelemente weitere, davon abgeleitete technische Hinweise und sich daraus eröffnende Handlungsoptionen bereitgestellt. Unabhängig von konkreten technischen Maßnahmen, welche üblicherweise zur Verhinderung von Leistungsabfall und Zerstörung der Halbleiterbauelemente implementiert sind, werden Vorschläge und/oder Warnungen für den anwendungsbezogenen Nutzer aufgezeigt, sein Nutzungsverhalten einem ggf. technisch kritischen Alterungszustand der Halbleiterbauelemente anzupassen. Es ist vorteilhaft, die Informationen über den Alterungszustand der Halbleiterbauelemente mittels eines Kommunikationssystems an ein, insbesondere in Fahrzeugen vorhandenes, Informations- und/oder Diagnosesystem bereitzustellen. Das Informations- und/oder Diagnosesystem kann dann die technischen Hinweise und entsprechenden Handlungsoptionen ableiten und dem anwendungsbezogenen Nutzer visuell und/oder akustisch und/oder via mechanischem Feedback bereitstellen.

Damit der Leistungsabfall und die drohende Zerstörung der Halbleiterbauelemente sowie daraus resultierende Auswirkungen auf abhängige Komponenten rechtzeitig erkannt und behoben werden können, ist eine, insbesondere zu Vermeidung von technischen Ausfällen der Halbleiterelemente, zeitnahe Übermittlung der Informationen zum Alterungszustand der Halbleiterbauelemente an den anwendungsbezogenen Nutzer wie auch an entsprechende Hersteller und ausgewählte Wartungs- und Instandhaltungsdienstleister vorteilhaft. Für die zeitnahe Übermittlung der Informationen zum Alterungszustand der Halbleiterbauelemente können beispielsweise Kommunikationstransfers angesehen werden, wie sie für eine Kommunikation in Internet-Netzen mit oder ohne drahtloser Kommunikationsverbindungen üblich sind.

Die Hersteller von Halbleiterbauelementen, wie auch die Hersteller, welche die Halbleiterbauelemente in ihre Produkte integrieren, haben von den erfindungsgemäßen Informationen über den Alterungszustand der Halbleiterbauelemente künftig einen Wettbewerbsvorteil. Sie können unter realen Betriebsbedingungen zuverlässiger die Lebensdauer der Halbleiterbauelemente abschätzen, somit auch exaktere Aussagen zur Zuverlässigkeit ihrer höher integrierten Produkte abgeben und darüber hinaus gewonnene Erkenntnisse in eine effizientere Entwicklung zur Verbesserung ihrer Produkte einfließen lassen.

Zeichnet sich nun ein notwendiger Austausch der Halbleiterbauelemente sowie eventuell von ihnen abhängiger Komponenten ab, kann sich der Wartungs- und Instandhaltungsdienstleister, mittels der zeitnahen Übermittlung der Informationen über den Alterungszustand der Halbleiterbauelemente an ihn, logistisch und technisch darauf vorbereiten. Insbesondere die Anforderungen einer vorbeugenden Wartung werden wesentlich unterstützt. Eine darauf ausgerichtete Planung zum Austausch der mit dem vorgeschlagenen Verfahren Halbleiterbauelemente kann nunmehr vorteilhaft sicherstellen, dass materielle und personelle Ressourcen kosten- und termingerechter eingesetzt werden.

Die zeitnahe Übermittlung der Informationen über den Alterungszustand der Halbleiterbauelemente wird mittels Kommunikationsverbindungen, insbesondere mittels drahtloser Kommunikationsverbindungen, zwischen einem Kommunikationssystem, welches sich am Einbauort der Halbleiterbauelemente befindet, und Kommunikationssystemen, auf welche die Hersteller und die Wartungs- und Instandhaltungsdienstleister jeweils vor Ort Zugriff haben, durchgeführt. Alle benannten Kommunikationssysteme stellen im Allgemeinen immer auch die geeigneten Kommunikationsverbindungen zur Kommunikation bereit.

Es ist weiterhin vorteilhaft, das Kommunikationssystem mit geeigneten Kommunikationsverbindungen in die Leistungshalbleitervorrichtung zu intergieren und es somit nahe am Einbauort der Halbleiterbauelemente anzuordnen. Das Informations- und/oder Diagnosesystem, welches dem anwendungsbezogene Nutzer die aus den Informationen über den Alterungszustand der Halbleiterbauelemente abgeleiteten technischen Hinweisen und entsprechenden Handlungsoptionen visuell und/oder akustisch bereitstellt, ist mit dem Kommunikationssystem am Einbauort der Halbleiterbauelemente, welches die Informationen über die Alterungszustände der Halbleiterbauelemente aufnimmt, kommunikativ verbunden.

Zur weiteren Verarbeitung und Darstellung der Informationen über den Alterungszustand der Halbleiterbauelemente werden von den entsprechenden Herstellern sowie ausgewählten Wartungs- und Instandhaltungsdienstleistern entsprechende Informations- und/oder Diagnosesysteme eingesetzt, wobei diese Informations- und/oder Diagnosesysteme vor Ort mit den jeweiligen Kommunikationssystemen kommunikativ verbunden sind.

Die vorliegende Erfindung wird nun anhand der beigefügten Zeichnungen näher erläutert, in denen zeigen:
- FIG 1: eine schematische Darstellung zur Gewinnung einer Information über den Alterungszustand von Stromrichterkomponenten eines Fahrzeugs gemäß der vorliegenden Erfindung;
- FIG 2: eine Schaltungsanordnung zur Messung von elektrischen Größen in einer Halbbrücke;
- FIG 3: eine Kennlinie der virtuellen Sperrschichttemperatur über der Kollektor-Emitter-Spannung;
- FIG 4: den prinzipiellen Verfahrensablauf zum Gewinnen einer Information über den Alterungszustand eines Leistungshalbleiterbauelements; und
- FIG 5: einen prinzipiellen Aufbau eines Kühlsystems für drei Halbbrücken eines Stromrichters.

Die nachfolgend näher geschilderten Ausführungsbeispiele stellen bevorzugte Ausführungsformen der vorliegenden Erfindung dar.

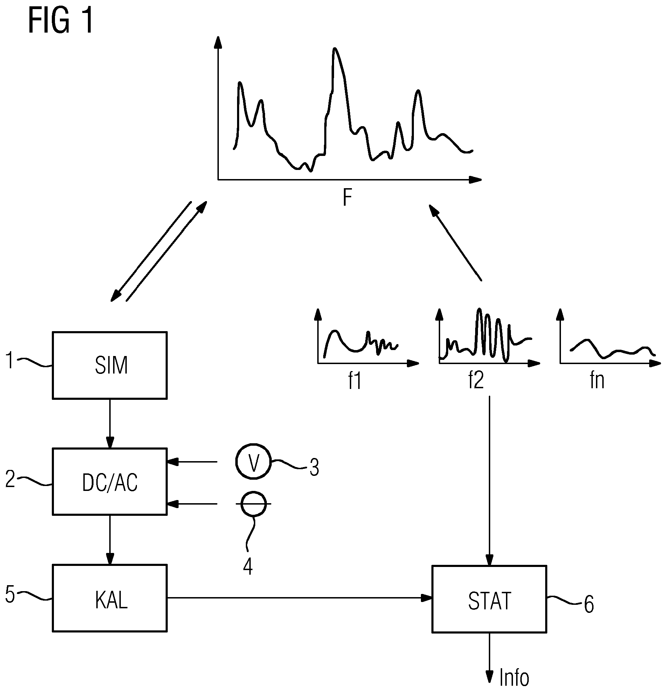

Die Lebensdauersimulation dient weiterhin zur unverzichtbaren grundlegenden Auslegung der Leistungshalbleiter. Anhand von FIG 1 wird erläutert, wie bislang die Lebensdauer von Leistungshableiterbauelementen ermittelt wurde und welchen Beitrag die vorliegende Erfindung leistet. Das Beispiel von FIG 1 bezieht sich auf den Stromrichter bzw. Umrichter eines elektrisch betriebenen Fahrzeugs. Die Information über den Alterungszustand kann aber auch für beliebige andere Leistungshalbleiter auf ähnliche Weise erfolgen.

Ein Autohersteller gewinnt aus mehreren tatsächlich aufgezeichneten individuellen Fahrprofilen f1, f2,..., fn ein typisches (ggf. mittleres) Fahrprofil F als Abbild der n Einzelprofile. Aus dem mittleren Fahrprofil F bzw. einem entsprechenden Nutzungsprofil des jeweiligen Halbleiters kann eine mittlere Lebensdauer des Leistungshalbleiters durch Simulation 1 (SIM) durchgeführt werden. Am Beispiel des Kraftfahrzeugs soll vorzugsweise die zu erwartende Lebensdauer eines IGBT (oder MOSFET) der Umrichterendstufe abgeschätzt werden. Dazu wird bei der Simulation 1 das Fahrprofil F in ein Temperaturprofil für den Umrichter umgerechnet. Anschließend wird das Temperaturprofil auf eine vom Leistungshalbleiterhersteller bereitgestellte Lebensdauerkurve abgebildet. Daraus lässt sich dann die Lebensdauer der IGBTs der Stromrichter bzw. Umrichter für ein durchschnittliches Fahrprofil F schätzen. Tatsächlich liegen aber für die n verschiedenen Fahrer jeweils unterschiedliche Fahrzyklen vor, sodass sich auch die Lebensdauer der Leistungshalbleiter im jeweiligen Fahrzeug unterscheiden. Wünschenswert ist es, für das individuelle Fahrzeug das Lebensdauerende der Leistungshalbleiter abschätzen zu können.

Um eine Abschätzung der Lebensdauer eines mit einem konkreten, individuellen Nutzungsprofil genutzten Leistungshableiterbauelements vornehmen zu können, wird daher im vorliegenden Beispiel der Umrichter 2 mit einer Spannungsmesseinrichtung 3 und einer Messstromquelle 4 ausgestattet. Mit diesen in den Stromrichter 2 zusätzlich integrierten Komponenten 3, 4 erfolgt am Ende des Herstellungsprozesses des Stromrichters bei der Endprüfung vorzugsweise eine sogenannte "aktive Kalibrierung". Dabei wird die Kennlinie der virtuellen Sperrschichttemperatur gegenüber der Kollektor-Emitter-Spannung mit der Messstromquelle 4 ermittelt, die einen verhältnismäßig geringen Messstrom (z.B. 500 mA) liefert. Das Aufheizen des Leistungshalbleiterbauelements erfolgt mit der wesentlich leistungsstärkeren Laststromquelle. Der zusätzliche Zeitaufwand für die "aktive Kalibrierung" beträgt je Umrichter ca. 15 s bis 30 s. Eine zusätzliche Messausstattung neben einem Temperatursensor ist nicht nötig.

Anhand der Kalibrierung und einem individuellen Fahrprofil kann nun eine Recheneinrichtung 6 einen Lebensdauerstatus des Leistungshalbleiters berechnen und eine entsprechende Information ausgeben. Diese Information (Info) kann den aktuellen Lebensalterzustand des Halbleiterbauelements betreffen oder eine Schätzung der restlichen Lebensdauer. Letztere kann sich auf eine Fortschreibung des individuellen Fahrprofils und/oder auf ein Fahrprofil mit verminderter Leistungsaufnahme beziehen.

Es wird somit ein tatsächlicher Bezug zwischen der Bestimmung des Alterungszustands und dem individuellen Fahrprofil hergestellt. Jeder Stromrichter lässt sich somit individuell überwachen. So lässt sich beispielsweise beim Motorstart oder nach dem Abstellen des Fahrzeugs ein entsprechender Test durchführen, der ca. 1/5 der Zeit bei der Endprüfung (vgl. Kalibrierung 5) dauert, also ca. 3 bis 6 s.

Ist die Höhe der Alterung festgestellt, so können entsprechende Schritte eingeleitet werden. Beispielsweise kann bei geringer Alterung die folgende Information an den Fahrer abgegeben werden: "Bitte Werkstatt aufsuchen". Bei fortgeschrittener Alterung kann zusätzlich zu der Information an den Fahrer eine Drosselung der Umrichterleistung erfolgen.

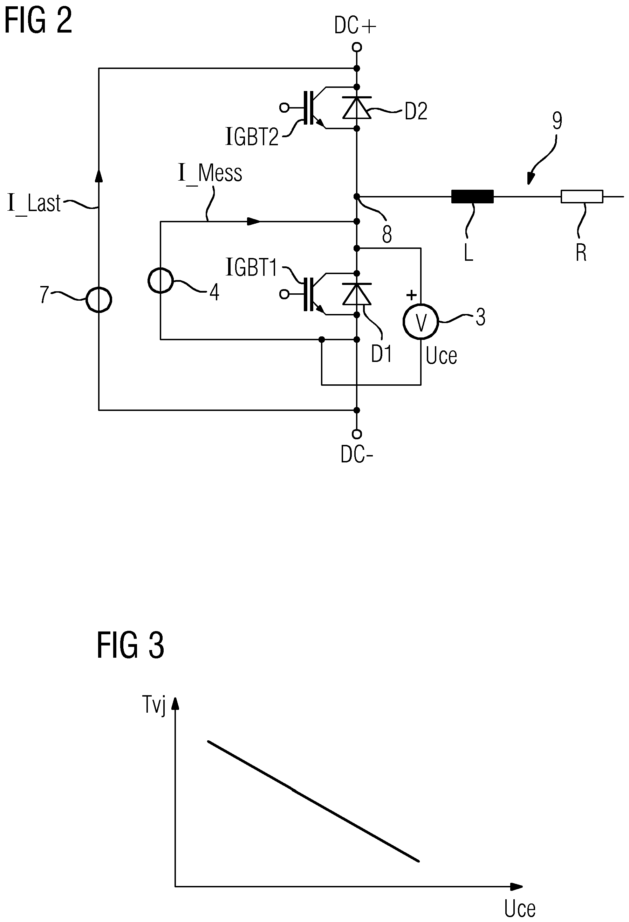

FIG 2 zeigt einen Teil eines Stromrichters, wie er üblicherweise in elektrisch betriebenen Fahrzeugen eingesetzt wird. Ein erster IGBT 1 und ein zweiter IGBT 2, denen jeweils eine Freilaufdiode D1, D2 parallel geschaltet ist, bilden eine Halbbrücke und sind seriell an einen Zwischenkreis mit den Klemmen DC- und DC+ geschaltet. Eine Laststromquelle 7, die einen Laststrom I Last liefert, symbolisiert den Zwischenkreis. An einem Mittelabgriff 8 zwischen den beiden IGBTs hängt eine Last 9, die durch eine Induktivität L und einen Widerstand R symbolisiert ist. Zwischen dem Mittelabgriff 8 und der Induktivität L kann ein Shunt oder ein anderer Stromsensor vorgesehen sein, um eine Strommessung für die Bestimmung der Verlustleistung (siehe unten) durchführen zu können.

Erfindungsgemäß ist nun an die Kollektor-Emitter-Strecke oder eine Hilfskollektor-Hilfsemitter-Strecke des ersten IGBT 1 der Spannungsmesser 3 angeschlossen. Darüber hinaus ist die Messstromquelle 4 zwischen den Emitter des IGBT 1 und den Mittelabgriff 8 oder zwischen Hilfsemitter und Hilfskollektor geschaltet. Sie liefert einen Messstrom I_Mess. Mit dieser zusätzlichen Messeinrichtung (u. a. Spannungsmesser 3 und Messstromquelle 4) können im Feld Lebensdauerüberwachungsfunktionen gewährleistet werden, wie sie bei üblichen Lastwechseltests eingesetzt werden. Zum einen lässt sich eine Durchlassspannungsmessung bei Laststrom I_Last durchführen. Zum anderen lässt sich eine Durchlassspannungsmessung bei einem sehr kleinen Messstrom durchführen, der durch die zusätzlich benötigte Stromquelle 4 getrieben wird und vorzugsweise etwa 0,025 bis 0,1 % des Nennstroms des Leistungshalbleiterbauelements beträgt. Mit der Durchlassspannung bei Laststrom werden Bondabgänge, und bei Messstrom werde Schichtdegradationen (Verschlechterungen des thermischen Widerstands via Sperrschichttemperaturermittlung) erkannt.

Die Messung bei Messstrom benötigt die bereits erwähnte Kalibrierung 5. Vorzugsweise wird die in der nachveröffentlichten DE 10 2012 005 815 beschriebene "aktive Kalibrierung" durchgeführt, die weniger als eine Minute dauert.
Die aktive Kalibrierung zeichnet sich dadurch aus, dass die Temperaturkalibrierkennlinie durch aktive Erwärmung der Prüflinge durch ihre eigene Verlustleistung gewonnen wird. Bei der Kalibrierung im Messaufbau wird das Modul in Form des Halbleiterbauelements der Leistungselektronik aktiv, das heißt mit einem Laststrom, geheizt. Der Aufheizvorgang geschieht in einem oder mehreren Intervallen. Das Halbleiterbauelement wird nicht gekühlt, lediglich die thermischen Kapazitäten des Wasserkühlers oder des Luftkühlers bei abgeschaltetem Lüfter laden sich auf. Über den Laststrom und die sich dadurch einstellende Vorwärtsspannung wird der Chip im Modul für eine definierte Zeit aktiv geheizt. Nach dem Abschalten des Laststroms wird der Messstrom über die Leistungsanschlüsse eingespeist. Natürlich kann der Messstrom auch bei fließendem Laststrom eingespeist werden, da die aus dem fließenden Messstrom resultierende Erwärmung gegenüber der aus dem Laststrom vernachlässigbar ist. Anfangs sinkt die Temperatur über dem Chip stark ab. Die thermischen Kapazitäten des Halbleiterbauelements entladen sich über die entsprechenden thermischen Widerstände in den Kühler. Dabei erreicht die Chiptemperatur nach einer bestimmten Zeit annähernd die Temperatur des Kühlkörpers. Danach sinken beide gleich schnell ab. Die Zeit, bis sich beide Temperaturen etwa auf dem gleichen Niveau befinden, lässt sich aus der größten thermischen Hauptzeitkonstante des Halbleiterbauelements abschätzen. Die thermische Hauptzeitkonstante lässt sich aus den Herstellerangaben ermitteln, ist eine durch den Hersteller ermittelte Angabe oder lässt sich abschätzen.

Bei der Kalibrierung 5, die automatisch durchführbar ist und somit für ein Serienprodukt geeignet ist, wird eine Kalibrierkennlinie ermittelt, die für typische Fälle in FIG 3 dargestellt ist. Mit abnehmender virtueller Sperrschichttemperatur Tvj steigt die Kollektor-Emitter-Spannung Uce und es gilt allgemein: Uce=f(Tvj) bei kleinem Messstrom.

Im konkreten Fall wird der Stromrichter bzw. ein Halbleiterbauelement von ihm bei deaktivierter Kühlung durch die Laststromquelle 7 vorzugsweise gepulst mit Strom versorgt. Beispielsweise wird also ein IGBT bei entsprechender Ansteuerung aus dem Zwischenkreis gespeist, wodurch ein Stromfluss I_Last durch den IGBT 1 und die Last 9 entsteht und den IGBT, also das Halbleiterbauelement, aufheizt. Die Last ist bei der Endprüfung meist eine Drossel oder ein Elektromotor im Prüffeld. Nach Inbetriebnahme des Halbleiterbauelements ist die Last im Falle eines Kraftfahrzeugs dessen Elektromotor.

Nach dem Abschalten des Laststroms wird das Temperaturequilibrium im Leistungshalbleiter abgewartet, was ca. 3 bis 10 s dauern kann. Nun wird der Messstrom I_Mess von der Messstromquelle 4 eingespeist und ein Wertepaar der Kalibrierkennlinie {Uce; Tvj} aufgenommen. Dies wird einmal oder mehrfach wiederholt ("aktive Kalibrierung"). Die Kalibrierung kann selbstverständlich auch mit anderen Methoden gewonnen werden.

Der Temperaturwert bei der Kalibrierung wird beispielsweise durch einen NTC-Widerstand (negativer Temperaturkoeffizient) gewonnen. Die resultierende Kalibrierkennlinie (vgl. FIG 3) wird im Umrichter bzw. Stromrichter gespeichert. Gleichzeitig wird die Vorwärtsspannung bei Laststrom I_Last gemessen (z. B. mittels des oben bereits erwähnten Shunt) und ebenfalls gespeichert. Eine Kalibrierung der elektronischen Bauteile ist insoweit nicht notwendig, als sich systematische Fehler bei der Kalibrierung und bei der Messung kompensieren.

Im Feld wird bei entsprechenden Gelegenheiten (z. B. Start des Motors oder nach Abstellen des Motors) der IGBT vergleichbar zur Endprüfung gepulst mit Strom versorgt. Die Last 9 ist nun die Motorwicklung. Dabei wird der Vorwärtsspannungsabfall Uce bei Laststrom I_Last (Bondabgang) und bei Messstrom I_Mess (thermischer Widerstand) gemessen und mit dem bei der Endprüfung gewonnenen Referenzwert Rth,ref von der Endprüfung (d.h. vor der Inbetriebnahme des Halbleiterbauelements) verglichen. Über die Abweichungen werden Alterungszustände ermittelt.

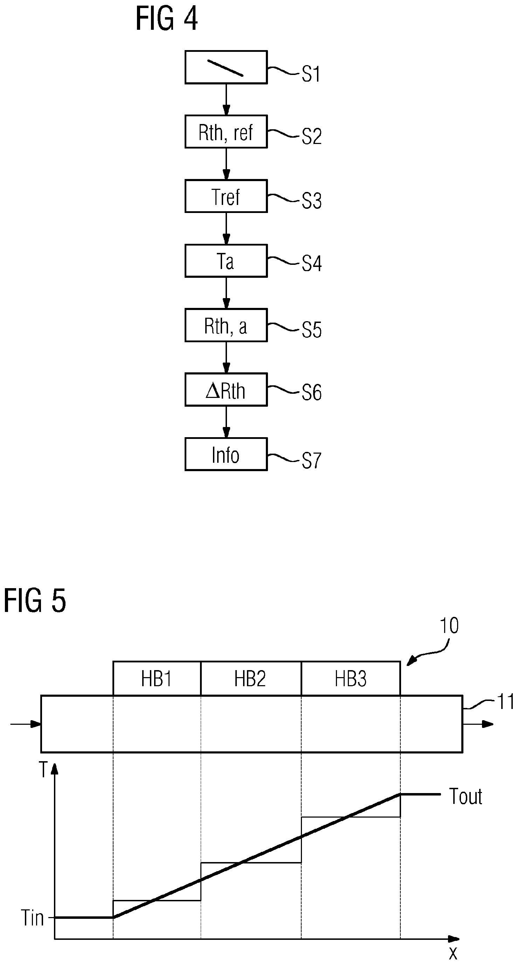

Die Bestimmung eines Alterungszustands eines Halbleiterbauelements in der Leistungselektronik (kurz Leistungshalbleiterbauelement bzw. Leistungshalbleiter) wird nun im Zusammenhang mit FIG 4 näher erläutert. Zunächst wird in Schritt S1 bei der Endprüfung, d.h. vor Inbetriebnahme des Halbleiterbauelements, die erwähnte Kalibrierung durchgeführt, um die Temperaturkennlinie gemäß FIG 3 zu ermitteln. Neben der beschriebenen "aktiven Kalibrierung" kann auch die übliche "passive Kalibrierung" oder eine andere Kalibrierung durchgeführt werden.

Vor der Inbetriebnahme des Halbleiterbauelements wird gemäß Schritt S2 außerdem ein Referenzwert Rth,ref für den thermischen Widerstand von dem Halbleiterbauelement nach außen, z.B. zu einer Wärmesenke (Kühler) ermittelt. Der thermische Widerstand ist der Quotient aus Temperaturhub und Verlustleistung, d.h. Rth=ΔT/Pv. Dabei entspricht die Verlustleistung beispielsweise dem Produkt aus dem Laststrom I_Last durch den IGBT 1 und der Vorwärtsspannung Uce am IGBT 1 (gemessen durch die Spannungsmesseinheit 3). Der Temperaturhub ΔT wird wie in den nachfolgenden Schritten S3 und S4 bestimmt. Vor Inbetriebnahme des Halbleiterbauelements ist der Schichtaufbau des Halbleiterbauelements noch nicht gealtert und es resultiert der Referenzwert Rth,ref.

Nach Inbetriebnahme des Halbleiterbauelements soll nun ein konkreter Alterungszustand festgestellt werden bzw. eine Vorhersage für eine Restlebensdauer gegeben werden. Dazu wird zunächst in Schritt S3 eine Referenztemperatur Tref des Halbleiterbauelements ermittelt, indem die Spannung Uce am Halbleiterbauelement IGBT 1 gemessen wird und anschließend anhand der Kennlinie (vgl. FIG 3) die korrespondierende Sperrschichttemperatur als Tref ermittelt wird.

In einem anschließenden Schritt S4 wird das Halbleiterbauelement erwärmt und es wird eine aktuelle Temperatur Ta ermittelt. Das Erwärmen des Halbleiterbauelements erfolgt beispielsweise durch einen kurzen Laststromimpuls. Die Verluste im Halbleiterbauelement rufen die entsprechende Erwärmung hervor. Unmittelbar anschließend wird bei Messstrom die Kollektor-Emitter-Spannung (allgemein die Spannung an der Sperrschicht des Halbleiterbauelements) gemessen. Aus der Temperaturkennlinie von FIG 3 wird schließlich die aktuelle Temperatur Ta gewonnen.

In einem folgenden Schritt S5 wird der aktuelle thermische Widerstand Rth,a bestimmt, den das Halbleiterbauelement nun aktuell besitzt. Hierzu wird der Temperaturhub zwischen der aktuellen Temperatur Ta (aktueller Temperaturwert) und der in Schritt S3 bestimmten Referenztemperatur Tref (Temperaturreferenzwert) ermittelt. Der resultierende Temperaturhub wird dann durch die Verlustleistung dividiert, die zu dem Erwärmen des Halbleiterbauelements geführt hat.

In Schritt S6 wird der Unterschied ΔRth zwischen dem aktuellen thermischen Widerstand Rth,a und dem Widerstandsreferenzwert Rth,ref ermittelt und in Schritt S7 beispielsweise mit einem Schwellwert verglichen. Übersteigt der Unterschied ΔRth beispielsweise einen Schwellwert, so hat sich der thermische Widerstand des Halbleiterbauelements deutlich erhöht und es ist eine entsprechend hohe Alterung eingetreten. Folglich kann dem Fahrer oder einem Gerät eine korrespondierende Information ausgegeben werden. Die Information kann aber auch durch eine beliebige andere Operation in Abhängigkeit von dem Unterschied ΔRth generiert werden.

In einem konkreten Beispiel besitzt ein Stromrichter 10 eines elektrisch betriebenen Kraftfahrzeugs entsprechend FIG 5 unter anderem drei Halbbrücken HB1, HB2 und HB3. Diese werden von einer Kühleinrichtung gekühlt, welche von einem Kühlmedium (z.B. 50/50 Wasser/Glykol-Gemisch) durchflossen wird. Das Kühlmedium 11 strömt an den Halbbrücken HB1 bis HB3 seriell vorbei. Dies bedeutet, dass das Kühlmittel gemäß dem in FIG 5 dargestellten Temperaturverlauf zu Beginn die niedrigste Temperatur Tin besitzt, wenn es die Halbbrücke HB1 kühlt. Das Kühlmedium 11 heizt sich immer weiter auf, bis es am Ende die Verlustleistung (bzw. den Wärmestrom) der Halbbrücke HB3 aufgenommen hat und die Auslasstemperatur Tout erreicht hat. Dementsprechend ist auch bei symmetrischer Aufheizung die Halbbrücke HB3 wärmer als die Halbbrücke HB2, welche ihrerseits wärmer ist als die Halbbrücke HB1. Für die Bestimmung des Alterungszustands des Stromrichters reicht es daher, den Alterungszustand der Halbbrücke HB3 zu bestimmen. Dabei wiederum genügt es, einen IGBT oder eine Diode der Halbbrücke hinsichtlich ihres Alters zu analysieren.

In dem obigen Beispiel wird also eine "aktive Kalibriermethode" mit den aus Lastwechseltests bekannten Alterungsüberwachungsfunktionen in einem Serienumrichter zur Lebensdauerüberprüfung im Feld genutzt. Dem Fahrer kann bei Erkennen einer Alterung eine fallspezifische Information gegebene werden, dass beispielsweise eine Werkstatt aufzusuchen sei. Unter Umständen kann auch die Leistung des Umrichters bei fortgeschrittener Alterung gedrosselt werden. So wird ein Liegenbleiben des Fahrzeugs aufgrund alterungsbedingten Ausfalls der Leistungshalbleiter vermieden. Es kann vor einem etwaigen Ausfall reagiert werden. Alternativ kann die Erfindung auch bei anderen Applikationen besonders mit schwer vorhersagbaren tatsächlichen Belastungen eingesetzt werden, z. B. Windkraftanlagenumrichter. Dies ist besonders vorteilhaft, denn Offshore-Anlagen besitzen eine sehr geringe Erreichbarkeit und sind oftmals hohen Lastwechselbelastungen ausgesetzt. Die vorliegende Erfindung ist aber nicht auf Stromrichter, geschweige denn auf Stromrichter mit Halbbrücken begrenzt. Vielmehr kann die vorliegende Erfindung auch für anders eingesetzte Leistungshalbleiter genutzt werden.

Nachfolgend sind einige weitere konkrete Beispiele und Variationsmöglichkeiten geschildert. Beispielsweise genügt es, für die Kalibrierkennlinie zwei Punkte aufzunehmen: einen bei Raumtemperatur (komplett ohne Laststromfluss möglich) und einen bei etwa beispielsweise 90°C nach einem einzigen Stromimpuls von z.B. 5 s Länge. Auch die Stromstärke für diesen Stromimpuls kann variiert werden und muss nicht bei 100 % des Nennstroms oder 50 bis 100 % des Nennstroms liegen. Unter Umständen kann auch statt DC-Strom mit einem Wechselstrom bei taktenden Halbleitern erwärmt werden. Dies hätte den Vorteil, dass bei der üblichen Prüfung des Motors, die mit Wechselstrom stattfindet, der obere Punkt der Kennlinie gleich nach der Prüfung ermittelt werden kann. Der untere Punkt der Kennlinie kann dann nach Abkühlung oder bereits vor der Prüfung ermittelt werden. Die Ermittlung der Kennlinie ist somit in die Endprüfung besser integrierbar.

Die vorliegende Erfindung ist speziell auch für elektrisch betriebene Kraftfahrzeuge anwendbar, die mit einer Hochvolt-Batterie gespeist werden. Dementsprechend schalten die Stromrichter dort gegen die Zwischenkreisspannung, die bei Kraftfahrzeugen im Bereich von 400 V liegt. Bei Stromrichtern für Windkraftanlagen liegt die Zwischenkreisspannung zum Teil auch bei mehreren kV. Die Schaltfrequenzen von Umrichtern liegen in Automobilen und Windkraftanlagen meist im kHz-Bereich.

Bei den oben beschriebenen Feldmessungen hängt stets eine betriebsmäßig vorgesehene Last am Leistungshalbleiter. So ist beispielsweise bei einem verbauten Serienumrichter die Last der Motor (bei automotiven oder Industrieantrieben) bzw. der Generator (bei Windkraftanlagen). Der Strom für die Erwärmung der Leistungshalbleiter zur Rth-Bestimmung kann über eine Stromquelle oder ein Netz zur Verfügung gestellt werden. Aus Sicherheitsgründen ist es in der Regel notwendig, dass sich die elektrische Maschine im Wesentlichen bei dem Test nicht bewegt. Die Ansteuerung der Leistungshalbleiter bzw. des Stromrichters hat also entsprechend zu erfolgen.

Das Verfahren zur Ermittlung des Alterungszustands kann dadurch optimiert werden, dass Messungen mehrfach verwertet werden. So muss beispielsweise die Kollektor-Emitter-Spannung Uce bei Laststrom zur Bestimmung der Verlustleistung gemessen werden. Da diese Messung auch für die Ermittlung von Bondabgängen notwendig ist, können aus ihr zwei Informationen gewonnen werden.

## Patentansprüche

1. Verfahren zum Bereitstellen einer Information (Info) über einen Alterungszustand eines Halbleiterbauelements (IGBT1) der Leistungselektronik durch
- vor Inbetriebnahme des Halbleiterbauelements:
∘ Ermitteln (S1) einer Kennlinie einer Temperatur des Halbleiterbauelements gegenüber einer elektrischen Spannung an dem Halbleiterbauelement (IGBT1) und
∘ Ermitteln (S2) eines Widerstandreferenzwerts eines thermischen Widerstands des Halbleiterbauelements aus dem Quotienten eines Temperaturhubs und einer Verlustleistung des Halbleiterbauelements,
- nach Inbetriebnahme des Halbleiterbauelements:
∘ Messen (S3) einer Spannung an dem Halbleiterbauelement bei einem Messstrom und Bestimmen eines Temperaturreferenzwerts aus der gemessenen Spannung anhand der Kennlinie,
∘ Erwärmen (S4) des Halbleiterbauelements durch einen eine Verlustleistung hervorrufenden Laststrom, Messen einer aktuellen Spannung bei dem Messstrom an dem Halbleiterbauelement nach dem Erwärmen und Bestimmen eines aktuellen Temperaturwerts aus der aktuellen Spannung anhand der Kennlinie,
∘ Bestimmen (S5) eines aktuellen thermischen Widerstandswerts des Halbleiterelements aus einem Temperaturhub, der zwischen dem aktuellen Temperaturwert und dem Temperaturreferenzwert ermittelt wird, und der Verlustleistung,
∘ Ermitteln (S6) eines Unterschieds zwischen dem aktuellen thermischen Widerstandswert und dem Widerstandreferenzwert und
∘ Ausgeben (S7) der Information (Info) über den Alterungszustand des Halbleiterbauelements in Abhängigkeit von dem Unterschied,
wobei ein Kommunikationssystem zur Integration vorgesehen ist, welches Informationen über den Alterungszustand von Halbleiterbauelementen mittels geeigneter Kommunikationsverbindungen übermittelt, und
wobei in Abhängigkeit von der ausgegebenen Information (Info) eine Leistung des Halbleiterbauelements gesteuert wird.

2. Verfahren nach Anspruch 1, wobei der Temperaturwert eine virtuelle Temperatur einer Sperrschicht des Halbleiterbauelements (IGBT1) repräsentiert.

3. Verfahren nach Anspruch 1 oder 2, wobei der Messstrom um mindestens zwei Größenordnungen kleiner ist als der Laststrom.

4. Verfahren nach einem der vorhergehenden Ansprüche, wobei der Laststrom gepulst ist.

5. Verfahren nach einem der vorhergehenden Ansprüche, wobei das Halbleiterbauelement (IGBT1) an eine elektrische Maschine angeschlossen ist, und die elektrische Maschine mit dem Laststrom zum Erwärmen des Halbleiterbauelements so bestromt wird, dass sich die elektrische Maschine im Wesentlichen nicht bewegt.

6. Verfahren nach Anspruch 5, das unmittelbar vor dem Start oder nach dem Abstellen der elektrischen Maschine erfolgt.

7. Verfahren nach einem der vorhergehenden Ansprüche, wobei das Ermitteln (S1) der Kennlinie vor der Inbetriebnahme des Halbleiterbauelements mit denselben Mitteln erfolgt wie das Messen (S3) der Spannung an dem Halbleiterbauelement und das Erwärmen (S4) des Halbleiterbauelements nach Inbetriebnahme des Halbleiterbauelements.

8. Verfahren nach einem der vorhergehenden Ansprüche, wobei das Halbleiterbauelement (IGBT1) Teil eines Stromrichters (10) ist.

9. Verfahren nach Anspruch 8, wobei das Halbleiterbauelement (IGBT1) Teil einer von mehreren Halbbrücken des Stromrichters (10) ist, und wobei die Halbbrücken in Serie hintereinander von einem Kühlmittelstrom (11) gekühlt werden und nur von der im Kühlmittelstrom letzten Halbbrücke der Alterungszustand geschätzt wird.

10. Verfahren nach einem der vorhergehenden Ansprüche, wobei mittels der Informationen (Info) über den Alterungszustand der Halbleiterbauelemente (IGBT1) weitere, davon abgeleitete technische Hinweise und/oder sich daraus eröffnende Handlungsoptionen für einen anwendungsbezogenen Nutzer, insbesondere Vorschläge und/oder Warnungen zu seinem Nutzungsverhalten, bereitgestellt werden.

11. Verfahren nach einem der vorhergehenden Ansprüche, wobei die abgeleiteten technischen Hinweise und die sich daraus eröffnenden Handlungsoptionen für den anwendungsbezogenen Nutzer mittels eines insbesondere in Fahrzeugen vorhandenen Informations- und/oder Diagnosesystems visuell und/oder akustisch und/oder via mechanischem Feedback bereitgestellt werden.

12. Verfahren nach einem der Ansprüche 1 bis 9, wobei Informationen (Info) über den Alterungszustand der Halbleiterbauelemente (IGBT1) für Hersteller von Halbleiterbauelementen (IGBT1) und/oder für Hersteller von Produkten, welche Halbleiterbauelemente (IGBT1) intergieren, und/oder für Wartungs- und Instandhaltungsdienstleister, zur weiteren Verarbeitung und Darstellung mittels deren jeweiliger Informations- und/oder Diagnosesysteme, bereitgestellt werden.

13. Verfahren nach einem der vorhergehenden Ansprüche, wobei eine zeitnahe Übermittlung der Informationen zum Alterungszustand der Halbleiterbauelemente (IGBT1) an den anwendungsbezogenen Nutzer und/oder an entsprechende Hersteller und/oder an ausgewählte Wartungs- und Instandhaltungsdienstleister erfolgt.

14. Leistungshalbleitervorrichtung für eine elektrische Maschine mit
- einem Halbleiterbauelement (IGBT1) der Leistungselektronik,
- einer Speichereinrichtung, in der
∘ eine Kennlinie einer Temperatur des Halbleiterbauelements gegenüber einer elektrischen Spannung an dem Halbleiterbauelement sowie
∘ ein Widerstandreferenzwert eines thermischen Widerstands des Halbleiterbauelements aus dem Quotienten eines Temperaturhubs und einer Verlustleistung des Halbleiterbauelements gespeichert sind, und
- einer Messeinrichtung zum Durchführen folgender Schritte:
∘ Messen (S3) einer Spannung an dem Halbleiterbauelement bei einem Messstrom und Bestimmen eines Temperaturreferenzwerts aus der gemessenen Spannung anhand der Kennlinie,
∘ Erwärmen (S4) des Halbleiterbauelements durch einen eine Verlustleistung hervorrufenden Laststrom, Messen einer aktuellen Spannung bei dem Messstrom an dem Halbleiterbauelement nach dem Erwärmen und Bestimmen eines aktuellen Temperaturwerts aus der aktuellen Spannung anhand der Kennlinie,
∘ Bestimmen (S5) eines aktuellen thermischen Widerstandswerts des Halbleiterelements aus einem Temperaturhub, der zwischen dem aktuellen Temperaturwert und dem Temperaturreferenzwert ermittelt wird, und der Verlustleistung,
∘ Ermitteln (S6) eines Unterschieds zwischen dem aktuellen thermischen Widerstandswert und dem Widerstandreferenzwert und
∘ Ausgeben (S7) einer Information (Info) über einen Alterungszustand des Halbleiterbauelements in Abhängigkeit von dem Unterschied,
wobei ein Kommunikationssystem zur Integration vorgesehen ist, welches Informationen über den Alterungszustand von Halbleiterbauelementen mittels geeigneter Kommunikationsverbindungen übermittelt, und
wobei in Abhängigkeit von der ausgegebenen Information (Info) eine Leistung des Halbleiterbauelements gesteuert wird.

15. Leistungshalbleitervorrichtung nach Anspruch 14, die in ein Kraftfahrzeug, eine Photovoltaikanlage oder ein Windrad integriert ist.

## Claims

1. Method for providing information (Info) on an ageing status of a semiconductor component (IGBT1) of power electronics by
- prior to commissioning the semiconductor component:
• determining (S1) a characteristic curve of a temperature of the semiconductor component relative to an electric voltage on the semiconductor component (IGBT1) and
• determining (S2) a resistance reference value of a thermal resistance of the semiconductor component from the quotient of a temperature difference and a power loss of the semiconductor component,
- after commissioning the semiconductor component:
• measuring (S3) a voltage on the semiconductor component at a measuring current and determining a temperature reference value from the measured voltage on the basis of the characteristic curve,
• heating (S4) the semiconductor component by means of a load current producing a power loss, measuring a current voltage with the measuring current on the semiconductor component after heating and determining a current temperature value from the current voltage on the basis of the characteristic curve,
• determining (S5) a current thermal resistance value of the semiconductor component from a temperature difference, which is determined between the current temperature value and the temperature reference value, and the power loss,
• determining (S6) a difference between the current thermal resistance value and the resistance reference value and
• outputting (S7) the information (Info) on the ageing status of the semiconductor component as a function of the difference,
wherein a communication system is provided for integration, which transmits information on the ageing status of semiconductor components by means of suitable communication connections, and
wherein a power of the semiconductor component is controlled as a function of the output information (Info).

2. Method according to claim 1, wherein the temperature value represents a virtual temperature of a barrier layer of the semiconductor component (IGBT1).

3. Method according to claim 1 or 2, wherein the measuring current is smaller by at least two orders of magnitude than the load current.

4. Method according to one of the preceding claims, wherein the load current is pulsed.

5. Method according to one of the preceding claims, wherein the semiconductor component (IGBT1) is connected to an electric machine, and the electric machine is energized with the load current to heat the semiconductor component so that the electric machine essentially does not move.

6. Method according to claim 5, which is carried out immediately before the start or after the electric machine has parked.

7. Method according to one of the preceding claims, wherein the characteristic curve is determined (S1) before the semiconductor component is commissioned with the same means as the voltage is measured (S3) on the semiconductor component and the semiconductor component is heated (S4) after the semiconductor component is commissioned.

8. Method according to one of the preceding claims, wherein the semiconductor component (IGBT1) is part of a converter (10) .

9. Method according to claim 8, wherein the semiconductor component (IGBT1) is part of one of several half bridges of the converter (10), and wherein the half bridges are cooled in series one behind the other by a flow of coolant (11) and the ageing status is only estimated by the last half bridge in the flow of coolant.

10. Method according to one of the preceding claims, wherein the information (Info) on the ageing status of the semiconductor components (IGBT1) provides further technical details derived therefrom and/or courses of action made possible thereby for an application-oriented user, in particular proposals and/or warnings with respect to its usage pattern.

11. Method according to one of the preceding claims, wherein the derived technical details and the courses of action made possible thereby are provided visually and/or acoustically and/or via mechanical feedback for the application-oriented user by means of an information and/or diagnostic system which is available in particular in vehicles.

12. Method according to one of claims 1 to 9, wherein information (Info) on the ageing status of the semiconductor components (IGBT1) is provided for manufacturers of semiconductor components (IGBT1) and/or for manufacturers of products, which integrate semiconductor components (IGBT1), and/or for service and maintenance providers, for further processing and displaying by means of their respective information and/or diagnostic systems.

13. Method according to one of the preceding claims, wherein the information relating to the ageing status of the semiconductor components (IGBT1) is transmitted promptly to the application-oriented user and/or to corresponding manufacturers and/or to selected service and maintenance providers.

14. Power semiconductor device for an electric machine having
- a semiconductor component (IGBT1) of power electronics,
- a storage device, in which
• a characteristic curve of a temperature of the semiconductor component relative to an electric voltage on the semiconductor component and
• a resistance reference value of a thermal resistance of the semiconductor component from the quotient of a temperature difference and a power loss of the semiconductor component are stored, and
- a measuring device for carrying out the following steps:
• measuring (S3) a voltage on the semiconductor component at a measuring current and determining a temperature reference value from the measured voltage on the basis of the characteristic curve,
• heating (S4) the semiconductor component by means of a load current causing a power loss, measuring a current voltage in the measuring current on the semiconductor component after heating and determining a current temperature value from the current voltage on the basis of the characteristic curve,
• determining (S5) a current thermal resistance value of the semiconductor component from a temperature difference, which is determined between the current temperature value and the temperature reference value, and the power loss,
• determining (S6) a difference between the current thermal resistance value and the resistance reference value and
• outputting (S7) information (Info) on an ageing status of the semiconductor component as a function of the difference,
wherein a communication system is provided for integration, which transmits information on the ageing status of semiconductor components by means of suitable communication connections, and
wherein a power of the semiconductor component is controlled as a function of the output information (Info).

15. Power semiconductor device according to claim 14, which is integrated into a motor vehicle, a photovoltaic system or a wind turbine.

## Revendications

1. Procédé pour donner une information (Info) sur un état de vieillissement d'un composant (IGBT1) à semi-conducteur de l'électronique de puissance par
- avant la mise en service du composant à semi-conducteur :
∘ détermination (S1) d'une courbe caractéristique d'une température du composant à semi-conducteur en fonction d'une tension électrique appliquée au composant (IGBT1) à semi-conducteur et
∘ détermination (S2) d'une valeur de référence de résistance d'une résistance thermique du composant à semi-conducteur à partir du quotient d'une élévation de température par une puissance de perte du composant à semi-conducteur,-
- après la mise en service du composant à semi-conducteur :
∘ mesure (S3) d'une tension appliquée au composant à semi-conducteur pour un courant de mesure et détermination d'une valeur de référence de température à partir de la tension mesurée à l'aide de la courbe caractéristique,
∘ échauffement (S4) du composant à semi-conducteur par un courant de charge provoquant une puissance perdue, mesure d'une tension en cours au courant de mesure appliqué au composant à semi-conducteur après l'échauffement et détermination d'une valeur de température en cours à partir de la tension en cours à l'aide de la courbe caractéristique,
∘ détermination (S5) d'une valeur de résistance thermique en cours du composant à semi-conducteur à partir d'une élévation de température, qui est déterminée entre la valeur de température en cours et la valeur de référence de température, et de la puissance perdue,
∘ détermination (S6) d'une différence entre la valeur de résistance thermique en cours et la valeur de référence de résistance et
∘émission (S7) de l'information (Info) sur l'état de vieillissement du composant à semi-conducteur en fonction de la différence,
dans lequel il est prévu un système de communication pour l'intégration, qui transmet des informations sur l'état de vieillissement de composants à semi-conducteur au moyen de liaisons de communication appropriées, et
dans lequel on commande une puissance du composant à semi-conducteur en fonction de l'information (Info) émise.

2. Procédé suivant la revendication 1, dans lequel la valeur de température représente une température virtuelle d'une couche d'arrêt du composant (IGBT1) à semi-conducteur.

3. Procédé suivant la revendication 1 ou 2, dans lequel le courant de mesure est plus petit d'au moins deux ordres de grandeur que le courant de charge.

4. Procédé suivant l'une des revendications précédentes, dans lequel le courant de charge est pulsé.

5. Procédé suivant l'une des revendications précédentes, dans lequel le composant (IGBT1) à semi-conducteur est connecté à une machine électrique, et la machine électrique est alimentée en le courant de charge pour échauffer le composant à semi-conducteur, de manière à ce que la machine électrique ne se meuve sensiblement pas.

6. Procédé suivant la revendication 5, en ce qu'il est effectué, juste avant le démarrage ou après l'arrêt de la machine électrique.

7. Procédé suivant l'une des revendications précédentes, dans lequel la détermination (S1) de la courbe caractéristique s'effectue avant la mise en service du composant à semi-conducteur par les mêmes moyens que la mesure (S3) de la tension appliquée au composant à semi-conducteur et que l'échauffement (S4) du composant à semi-conducteur après la mise en service du composant à semi-conducteur.

8. Procédé suivant l'une des revendications précédentes, dans lequel le composant (IGBT1) à semi-conducteur fait partie d'un onduleur (10).

9. Procédé suivant la revendication 8, dans lequel le composant (IGBT1) à semi-conducteur fait partie d'un de plusieurs demi-ponts de l'onduleur (10), et dans lequel les demi-ponts, les uns derrière les autres en série, sont refroidis par un courant (11) de fluide de refroidissement et l'état de vieillissement n'est apprécié que par le dernier demi-pont dans le courant de fluide de refroidissement.

10. Procédé suivant l'une des revendications précédentes, dans lequel, au moyen de l'information (Info) sur l'état de vieillissement des composants (IGBT1) à semi-conducteur, on met à disposition d'autres indications techniques, qui s'en déduisent, et/ou d'autres options de manipulation, qui s'ouvrent à un utilisateur en ce qui concerne une utilisation, en particulier des propositions et/ou des avertissements en ce qui concerne son comportement à l'utilisation.

11. Procédé suivant l'une des revendications précédentes, dans lequel les indications techniques dérivées et les options de manipulation, qui s'ouvrent pour l'utilisateur en ce qui concerne l'utilisation, sont mises à disposition au moyen d'un système d'information et/ou de diagnostic visuellement et/ou de manière acoustique et/ou par un feedback mécanique.

12. Procédé suivant l'une des revendications 1 à 9, dans lequel on donne des informations (Info) sur l'état de vieillissement des composants (IGBT1) à semi-conducteur aux fabricants de composants (IGBT1) à semi-conducteur et/ou aux fabricants de produits, qui interréagissent avec des composants (IGBT1) à semi-conducteur et/ou des opérateurs de service d'entretien et de maintien en état pour le traitement ultérieur et la représentation, au moyen de leur système respectif d'information et/ou de diagnostic.

13. Procédé suivant l'une des revendications précédentes, dans lequel il est effectué une transmission, proche dans le temps, des informations sur l'état de vieillissement des composants (IGBT1) à semi-conducteur à l'utilisateur concerné par une utilisation et/ou à des fabricants correspondants et/ou à des opérateurs sélectionnés de service d'entretien et/ou de maintien en état.

14. Dispositif à semi-conducteur de puissance d'une machine électrique, comprenant
- un composant (IGBT) à semi-conducteur de l'électronique de puissance,
- un dispositif de mise en mémoire, dans lequel on met en mémoire
∘ une courbe caractéristique d'une température du composant à semi-conducteur en fonction d'une tension électrique appliquée au composant à semi-conducteur, ainsi que
∘ une valeur de référence de résistance d'une résistance thermique du composant à semi-conducteur à partir du quotient d'une élévation de température par une puissance perdue du composant à semi-conducteur, et
- un dispositif de mesure pour effectuer les stades suivants :
∘ mesure (S3) d'une tension appliquée au composant à semi-conducteur pour un courant de mesure et détermination d'une valeur de référence de température à partir de la tension mesurée à l'aide de la courbe caractéristique,
∘ échauffement (S4) du composant à semi-conducteur par un courant de charge provoquant une perte de puissance, mesure d'une tension en cours au courant de mesure appliqué au composant à semi-conducteur après l'échauffement et détermination d'une valeur de température en cours à partir de la tension en cours à l'aide de la courbe caractéristique,
∘ détermination (S5) d'une valeur de résistance thermique en cours du composant à semi-conducteur à partir d'une élévation de température, qui est déterminée entre la valeur de température en cours et la valeur de référence de température, et de la puissance perdue,
∘ détermination (S6) d'une différence entre la valeur de résistance thermique en cours et la valeur de référence de résistance et
∘ émission (S7) de l'information (Info) sur l'état de vieillissement du composant à semi-conducteur en fonction de la différence,
dans lequel il est prévu un système de communication pour l'intégration, qui transmet des informations sur l'état de vieillissement de composants à semi-conducteur au moyen de liaisons de communication appropriées, et
dans lequel on commande une puissance du composant à semi-conducteur en fonction de l'information (Info) émise.

15. Dispositif à semi-conducteur de puissance suivant la revendication 1, qui est intégré à un véhicule automobile, à une installation photovoltaïque ou à une éolienne.
